(19) Europäisches Patentamt
European Patent Office
Office européen des brevets

(11) **EP 4 633 308 A1**

(12) **EUROPEAN PATENT APPLICATION**
published in accordance with Art. 153(4) EPC

(43) Date of publication:
**15.10.2025 Bulletin 2025/42**

(21) Application number: **24829817.6**

(22) Date of filing: **05.02.2024**

(51) International Patent Classification (IPC):
**H05K 7/20** (2006.01)

(52) Cooperative Patent Classification (CPC):
Y02T 10/70

(86) International application number:
**PCT/CN2024/076053**

(87) International publication number:
**WO 2025/001157 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.06.2023 CN 202310776258**

(71) Applicant: **Chongqing Changan Automobile Co.,
Ltd.
Chongqing 400023 (CN)**

(72) Inventors:
• **ZHEN, Taoxing
Chongqing 400023 (CN)**
• **YU, Binbin
Chongqing 400023 (CN)**

(74) Representative: **Keller Schneider
Patent- und Markenanwälte AG
Eigerstrasse 2
Postfach
3000 Bern 14 (CH)**

(54) **COOLING CONTROL METHOD AND SYSTEM FOR VEHICLE-MOUNTED POWER SOURCE
SYSTEM, AND VEHICLE AND STORAGE MEDIUM**

(57) The present invention discloses a cooling control method and system for an on-board power supply system, a vehicle, and a storage medium. The method includes: acquiring, in real time, a working state, a water inlet coolant temperature and an internal component temperature of the on-board power supply system, as well as a real-time input voltage, a real-time input current, a real-time output voltage and a real-time output current of the on-board power supply system in a current working mode; calculating a theoretical cooling flow demand corresponding to the current working mode; calculating a target cooling flow demand value of the on-board power supply system; and according to the target cooling flow demand value, performing a lookup operation in a relation table between a duty ratio of a water pump and a flow rate thereof to obtain a real-time target duty ratio of the water pump, and based on the real-time target duty ratio of the water pump, controlling operation of the water pump in a closed-loop manner. The present invention implements adaptive and active flow adjustment of an on-board power supply system.

Acquire, in real time, a working state, a water inlet coolant temperature and an internal component temperature of the on-board power supply system, as well as a real-time input voltage, a real-time input current, a real-time output voltage and a real-time output current of the on-board power supply system in a current working mode

↓

Calculate a theoretical cooling flow demand corresponding to the current working mode, and calculate a target cooling flow demand value of the on-board power supply system

↓

According to the target cooling flow demand value, perform a lookup operation in a relation table between a duty ratio of a water pump and a flow rate thereof to obtain a real-time target duty ratio of the water pump, and based on the real-time target duty ratio of the water pump, control operation of the water pump in a closed-loop manner

Fig. 2

Processed by Luminess, 75001 PARIS (FR)

## Description

### TECHNICAL FIELD

The present invention relates to the field of automotive thermal management technology, and in particular relates to a cooling control method and system for an on-board power supply system, a vehicle, and a storage medium.

### BACKGROUND

An on-board power supply system is a two-in-one system that integrates an on-board charger and a DCDC, and is mainly applied to new energy vehicles to achieve functions such as AC charging and discharging, converting high-voltage electricity of a power battery into low-voltage electricity, supplying power to low-voltage loads of a whole vehicle, and charging a storage battery. The on-board power supply system generates heat during operation due to switching and conduction loss of internal power components, etc., and needs to be cooled by a cooling medium to ensure that the internal components do not suffer thermal failure, which would otherwise affect its performance. Cooling requirements of the on-board power supply system are usually as follows: first, a water inlet temperature of the on-board power supply system does not exceed 85°C, wherein derating output is carried out when the water inlet temperature is higher than 65°C; second, an internal component temperature of the on-board power supply system needs to be within its corresponding limit.

Currently, an existing cooling control method for an on-board power supply system relies entirely on a vehicle thermal management controller to perform cooling control by acquiring, in real time, a water inlet coolant temperature of the on-board power supply system: adjusting a water pump and fan duty ratio by determining a gear interval in which the coolant temperature is located, wherein a coolant demand flow is within the range of 4-9 L/min. A water inlet coolant temperature gradient is detected: in the case of a first gear interval (<45°C), an output flow of a water pump is 4L/min; in the case of a second gear interval (45°C -50°C), an output flow of the water pump is 6L/min; and in the case of a third gear interval (≥50°C), or power derating operation of the on-board power supply system, an output flow of the water pump is 9L/min, and a fan is turned on for auxiliary heat dissipation. In such a cooling method, control is rough, broad and commonplace, and it cannot implement adaptive and refined active adjustment and control according to an actual cooling demand in conjunction with a specific technical solution of the on-board power supply system. Usually, a target requested flow is much larger than a real demanded flow, resulting in long-time high-speed operation of the water pump and the fan, poor NVH and high energy consumption. Moreover, such a cooling control method is not conducive to the selection of components such as the water pump, the fan and the radiator, and the cost of the cooling system is high.

Another example is a cooling control system and method for charging on-board equipment of an electric automobile disclosed in patent document CN110316006A. In this method, a temperature of an on-board charger is detected in real time and sent to a vehicle thermal management controller to determine whether the temperature of the on-board charger reaches a preset temperature value, and an instruction is sent to turn on a water pump if the set value is reached. In the cooling control of the on-board charger, the water pump is controlled only according to the temperature of on-board charger and the preset temperature. The condition is unitary and the water pump operates with a constant flow. It cannot implement flow adjustment according to power changes in a charging process, so the cooling process is not energy-saving.

Hence, there is a need to develop a cooling control method and system for an on-board power supply system, a vehicle, and a storage medium.

### SUMMARY OF THE INVENTION

An object of the present invention is to provide a cooling control method and system for an on-board power supply system, a vehicle, and a storage medium, capable of implementing adaptive and active flow adjustment of an on-board power supply system.

In a first aspect, a cooling control method for an on-board power supply system in the present invention includes the following steps:

acquiring, in real time, a working state, a water inlet coolant temperature and an internal component temperature of the on-board power supply system, as well as a real-time input voltage, a real-time input current, a real-time output voltage and a real-time output current of the on-board power supply system in a current working mode;

calculating a theoretical cooling flow demand corresponding to the current working mode according to an actual water inlet coolant temperature of the on-board power supply system, and a real-time input voltage, a real-time input current, a real-time output voltage and a real-time output current in a corresponding working mode; and according to a difference between a real-time temperature of each internal component of the on-board power supply system and a temperature threshold corresponding thereto, acquiring a flow correction coefficient corresponding to each internal component by referring to a correction coefficient map, taking the maximum of the flow correction coefficient(s) of all internal component(s) to obtain a flow correction coefficient of the on-board power supply system, and calculating a target cooling flow demand value of the on-board power supply system based on the flow correction coefficient of the on-board power supply system and the theoretical cooling flow demand; and

according to the target cooling flow demand value, performing a lookup operation in a relation table between a duty ratio of a water pump and a flow rate thereof to obtain a real-time target duty ratio of the water pump, and based on the real-time target duty ratio of the water pump, controlling operation of the water pump in a closed-loop manner.

Optionally, the method further includes:

calculating a real-time temperature difference between a real-time water inlet coolant temperature of the on-board power supply system and a power derating temperature threshold, and according to an interval corresponding to the real-time temperature difference, dynamically adjusting a fan gear to assist a radiator to dissipate heat.

Optionally, a real-time theoretical cooling flow demand is calculated in the following way:

a: according to the actual water inlet coolant temperature of the on-board power supply system, looking up a corresponding relation table between a heat dissipating quantity of the on-board power supply system and a base coolant flow rate, in a correspondence relation table between a coolant temperature and relation tables between the heat dissipating quantity of the on-board power supply system and the base flow rate;

b: calculating a theoretical heat dissipating quantity of the on-board power supply system according to the working mode of the on-board power supply system and the corresponding real-time input voltage, real-time input current, real-time output voltage and real-time output current; and

c: according to the current working mode and the theoretical heat dissipating quantity of the on-board power supply system, looking up a corresponding demanded base coolant flow rate, in the relation table between a heat dissipating quantity of the on-board power supply system and a base coolant flow rate that has been determined in the step a.

Optionally, in the step a, if the working mode identified is a charging mode, the theoretical heat dissipating quantity of the on-board power supply system is calculated in the following way:

$$Q_{ACDC}=U_{ACDC\_in}*I_{ACDC\_in}-U_{ACDC\_out}*I_{ACDC\_out}-U_{DCDC\_out}*I_{DCDC\_out}$$

wherein $Q_{ACDC}$ denotes a theoretical heat dissipating quantity when the on-board power supply system to be cooled is in the charging mode, $U_{ACDC\_in}$ denotes a real-time input voltage at an AC terminal of the on-board power supply system to be cooled, $I_{ACDC\_in}$ denotes a real-time input current at the AC terminal of the on-board power supply system to be cooled, $U_{ACDC\_out}$ denotes a real-time charging voltage of the on-board power supply system to be cooled, $I_{ACDC\_out}$ denotes a real-time charging current of the on-board power supply system to be cooled, $U_{DCDC\_out}$ denotes a DCDC low-voltage-side voltage of the on-board power supply system to be cooled, and $I_{DCDC\_out}$ denotes a DCDC low-voltage-side current of the on-board power supply system to be cooled.

Optionally, in the step a, if the working mode identified is a discharging mode, the theoretical heat dissipating quantity of the on-board power supply system is calculated in the following way:

$$Q_{DCAC}=U_{DCAC\_in}*I_{DCAC\_in}-U_{DCAC\_out}*I_{DCAC\_out}-U_{DCDC\_out}*I_{DCDC\_out}$$

wherein $Q_{DCAC}$ denotes a theoretical heat dissipating quantity when the on-board power supply system to be cooled is in the discharging mode, $U_{DCAC\_in}$ denotes a DCAC input voltage of the on-board power supply system to be cooled, $I_{DCAC\_in}$ denotes a DCAC input current of the on-board power supply system to be cooled, $U_{DCAC\_out}$ denotes a DCAC output voltage of the on-board power supply system to be cooled, $I_{DCAC\_out}$ denotes a DCAC output current of the on-board power supply system to be cooled, $U_{DCDC\_out}$ denotes a DCDC low-voltage-side voltage of the on-board power supply system to be cooled, and $I_{DCDC\_out}$ denotes a DCDC low-voltage-side current of the on-board power supply system to be cooled.

Optionally, in the step a, if the working mode identified is a DCDC mode,

the theoretical heat dissipating quantity of the on-board power supply system is calculated in the following way:

$$Q_{DCDC}=U_{DCDC\_in}*I_{DCDC\_in}-U_{DCDC\_out}*I_{DCDC\_out}$$

wherein $Q_{DCDC}$ denotes a theoretical heat dissipating quantity when the on-board power supply system to be cooled is in the DCDC mode, $U_{DCDC\_in}$ denotes a DCDC high-voltage-side voltage of the on-board power supply system to be cooled, $I_{DCDC\_in}$ denotes a DCDC high-voltage-side current of the on-board power supply system to be cooled, $U_{DCDC\_out}$ denotes a DCDC low-voltage-side voltage of the on-board power supply system to be cooled, and $I_{DCDC\_out}$ denotes a DCDC low-voltage-side current of the on-board power supply system to be cooled.

Optionally, the target cooling flow demand value is calculated in the following way:

$$CF_{\_Real}=CF_{\_Basic}*K_{int\_0}$$

wherein $CF_{\_Real}$ denotes the target cooling flow demand value; $CF_{\_Basic}$ denotes the theoretical cooling flow demand of the on-board power supply system; and $K_{int\_0}$ denotes the flow correction coefficient of the on-board power supply system.

In a second aspect, a cooling control system for an on-board power supply system in the present invention includes:

a parameter acquisition module configured to acquire a working state, a water inlet coolant temperature and an internal component temperature of the on-board power supply system, as well as a real-time input voltage, a real-time input current, a real-time output voltage and a real-time output current of the on-board power supply system in a current working mode;

a flow calculation module configured to calculate a theoretical cooling flow demand corresponding to the current working mode according to an actual water inlet coolant temperature of the on-board power supply system, and a real-time input voltage, a real-time input current, a real-time output voltage and a real-time output current in a corresponding working mode; and according to a difference between a real-time temperature of each internal component of the on-board power supply system and a temperature threshold corresponding thereto, acquire a flow correction coefficient corresponding to each internal component by referring to a correction coefficient map, take the maximum of the flow correction coefficient(s) of all internal component(s) to obtain a flow correction coefficient of the on-board power supply system, and calculate a target cooling flow demand value of the on-board power supply system based on the flow correction coefficient of the on-board power supply system and the theoretical cooling flow demand, wherein the flow calculation module is connected with the parameter acquisition module;

and a cooling control module configured to, according to the target cooling flow demand value, perform a lookup operation in a relation table between a duty ratio of a water pump and a flow rate thereof to obtain a real-time target duty ratio of the water pump, and based on the real-time target duty ratio of the water pump, control operation of the water pump in a closed-loop manner, wherein the cooling control module is connected with the flow calculation module.

optionally, the cooling control module is further configured to calculate a real-time temperature difference between a real-time water inlet coolant temperature of the on-board power supply system and a power derating temperature threshold, and according to an interval corresponding to the real-time temperature difference, dynamically adjust a fan gear to assist a radiator to dissipate heat.

Optionally, the parameter acquisition module includes:

a first parameter acquisition sub-module configured to acquire a current working mode of the on-board power supply system according to a current working state of an automobile and a using scenario thereof;

a second parameter acquisition sub-module configured to acquire a corresponding first flow calculation strategy when the current working mode of the on-board power supply system is a charging mode;

a third parameter acquisition sub-module configured to acquire a corresponding second flow calculation strategy when the current working mode of the on-board power supply system is a discharging mode; and

a fourth parameter acquisition sub-module configured to acquire a corresponding third flow calculation strategy when the current working mode of the on-board power supply system is a DCDC mode.

Optionally, the flow calculation module includes:

a first flow calculation sub-module configured to calculate a corresponding theoretical cooling flow demand when the current working mode of the on-board power supply system is the charging mode:

a second flow calculation sub-module configured to calculate a corresponding theoretical cooling flow demand when the current working mode of the on-board power supply system is the discharging mode;

a third flow calculation sub-module configured to calculate a corresponding theoretical cooling flow demand when the current working mode of the on-board power supply system is the DCDC mode;

a fourth flow calculation sub-module configured to calculate a corresponding target cooling flow demand value when the current working mode of the on-board power supply system is the charging mode;

a fifth flow calculation sub-module configured to calculate a corresponding target cooling flow demand value when the current working mode of the on-board power supply system is the discharging mode; and

a sixth flow calculation sub-module configured to calculate a corresponding target cooling flow demand value when the current working mode of the on-board power supply system is the DCDC mode.

Optionally, the cooling control module includes:

a first cooling control sub-module configured to, according to the target cooling flow demand value, perform a table lookup operation to obtain a corresponding duty ratio of the water pump, control the water pump to operate accordingly.

Optionally, the cooling control module includes:

a first cooling control sub-module configured to, according to the target cooling flow demand value, perform a table lookup operation to obtain a corresponding duty ratio of the water pump, control the water pump to operate accordingly; and

a second cooling control sub-module configured to, according to the target cooling flow demand value, perform a table lookup operation to obtain a corresponding duty ratio of a fan, and control the fan to operate accordingly.

**In** a third aspect, a vehicle in the present invention adopts a cooling control system for an on-board power supply system in the present invention.

**In** a fourth aspect, a storage medium in the present invention is configured to store a computer readable program which, when being called, performs steps of the cooling control method for an on-board power supply system in the present invention.

The present invention has the following advantages: in the present invention, a working state, a water inlet coolant temperature and an internal component temperature of the on-board power supply system, as well as a real-time input voltage, a real-time input current, a real-time output voltage and a real-time output current of the on-board power supply system in a current working mode are acquired in real time; a theoretical cooling flow demand corresponding to the current working mode is calculated according to an actual water inlet coolant temperature of the on-board power supply system, and a real-time input voltage, a real-time input current, a real-time output voltage and a real-time output current in a corresponding working mode; and according to a difference between a real-time temperature of each internal component of the on-board power supply system and a temperature threshold corresponding thereto, a flow correction coefficient corresponding to each internal component is acquired by referring to a correction coefficient map, the maximum of the flow correction coefficient(s) of all internal component(s) is taken to obtain a flow correction coefficient of the on-board power supply system, and a target cooling flow demand value of the on-board power supply system is calculated based on the flow correction coefficient of the on-board power supply system and the theoretical cooling flow demand; a theoretical flow of a motor controller to be cooled is calculated according to a real-time power of the motor controller and a real-time coolant temperature; and operation of a water pump is adaptively and dynamically adjusted according to a preset map of water pump flow versus duty ratio. In the present invention, operation of a fan is also actively adjusted in real time according to a preset map of water inlet coolant temperature of the on-board power supply system versus fan gear. In this method, the control of the water pump and the fan is based on a real-time flow demand of the on-board power supply system to implement active, adaptive and dynamic adjustment. Compared with a wide-range constant-current cooling method that usually determines a flow of a water pump based on a coolant temperature, the control is more accurate and refined, long-time high-speed operation of the water pump can be avoided, the NVH is significantly improved, and the cooling process is more energy-efficient under the premise of meeting the actual cooling demand of the on-board power supply system. Meanwhile, the selection of components of the cooling system can be optimized, and the cost of the whole vehicle is reduced.

## BRIEF DESCRIPTION OF THE DRAWINGS

To describe technical solutions in embodiments of the present invention more clearly, drawings to be used in the embodiments will be introduced briefly below. It should be understood that the following drawings only illustrate some embodiments of the present invention, and thus should not be regarded as limiting the scope, and those of ordinary skill in the art may also obtain other drawings according to these drawings without creative work.

Fig. 1 is a schematic structural diagram of a cooling circulation loop for an on-board power supply system provided in the present embodiment;

Fig. 2 a flow diagram I of a cooling control method for an on-board power supply system provided in the present embodiment;

Fig. 3 is a flow diagram II of a cooling control method for an on-board power supply system provided in the present embodiment;

Fig. 4 is a specific flow diagram of a cooling control method for an on-board power supply system provided in the present embodiment; and

Fig. 5 is a schematic block diagram of a cooling control apparatus for an on-board power supply system provided in the present embodiment.

Reference signs: 10 on-board power supply system; 11 water storage kettle; 12 water pump; 13 radiator; 14 fan; 15 temperature collector; 310 parameter acquisition module; 311 first parameter acquisition sub-module; 312 second parameter acquisition sub-module; 313 third parameter acquisition sub-module; 314 fourth parameter acquisition sub-module; 320 flow calculation module; 321 first flow calculation sub-module; 322 second flow calculation sub-module; 323 third flow calculation sub-module; 324 fourth flow calculation sub-module; 325 fifth flow calculation sub-module; 326 sixth flow calculation sub-module; 330 cooling control module; 331 first cooling control sub-module; 332 second cooling control sub-module.

## DETAILED DESCRIPTION

Embodiments of the present application will be described in more detail below with reference to the accompanying drawings. Although certain embodiments of the present application are illustrated in the drawings, it should be understood, however, that the present application may be implemented in various forms and should not be construed as being limited to the embodiments set forth herein. Instead, the embodiments are provided for the purpose of more thorough and complete understanding of the present application. It should be understood that the drawings and embodiments of the present application are for an exemplary purpose only and are not intended to limit the scope of protection of the present application.

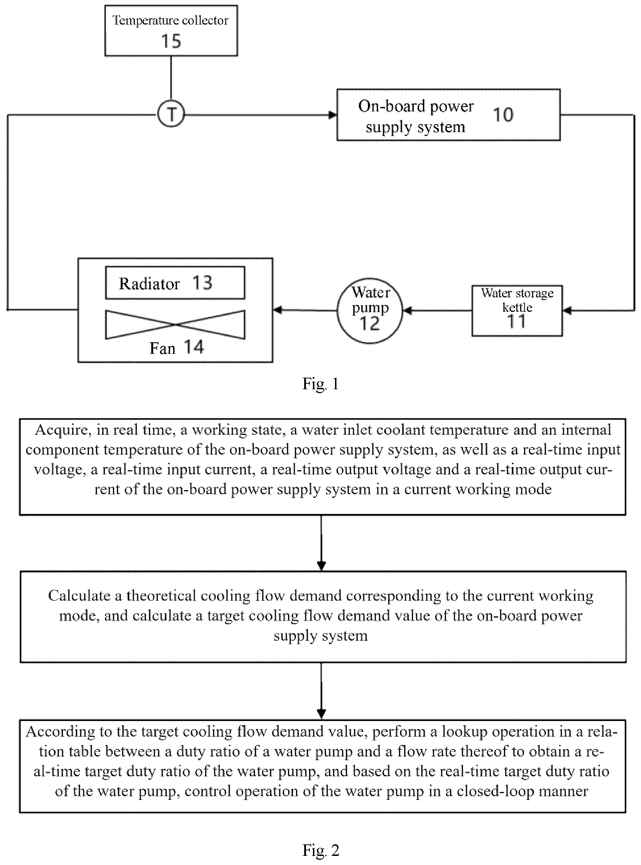

As shown in Fig. 1, which is a schematic structural diagram of a cooling circulation loop for an on-board power supply system, an on-board power supply system 10 that needs to be cooled is included, and a water pump 12 operates so that a coolant in the cooling circuit flows and circulates, wherein the coolant is mainly stored in a water storage kettle 11; a radiator 13 is used to dissipate heat from the coolant that have flowed out of the on-board power supply system 10 after flowing therethrough and exchanging heat therewith; a fan 14 is used to assist in cooling the radiator 13 and enhance a cooling effect of the radiator 13; and a temperature collector 15, collects, in real time, the temperature of the coolant flowing into a water inlet of the on-board power supply system 10 to dynamically adjust and control the water pump 12 and the fan 14 in real time.

As shown in Fig. 2, in present embodiment, a cooling control method for an on-board power supply system includes the following steps:

acquiring, in real time, a working state, a water inlet coolant temperature and an internal component temperature of the on-board power supply system, as well as a real-time input voltage, a real-time input current, a real-time output voltage and a real-time output current of the on-board power supply system in a current working mode;

calculating a theoretical cooling flow demand corresponding to the current working mode according to an actual water inlet coolant temperature of the on-board power supply system, and a real-time input voltage, a real-time input current, a real-time output voltage and a real-time output current in a corresponding working mode; and according to a difference between a real-time temperature of each internal component of the on-board power supply system and a temperature threshold corresponding thereto, acquiring a flow correction coefficient corresponding to each internal component by referring to a correction coefficient map, taking the maximum of the flow correction coefficient(s) of all internal component(s) to obtain a flow correction coefficient of the on-board power supply system, and calculating a target cooling flow demand value of the on-board power supply system based on the flow correction coefficient of the on-board power supply system and the theoretical cooling flow demand; and

according to the target cooling flow demand value, performing a lookup operation in a relation table between a duty ratio of a water pump and a flow rate thereof to obtain a real-time target duty ratio of the water pump, and based on the real-time target duty ratio of the water pump, controlling operation of the water pump in a closed-loop manner.

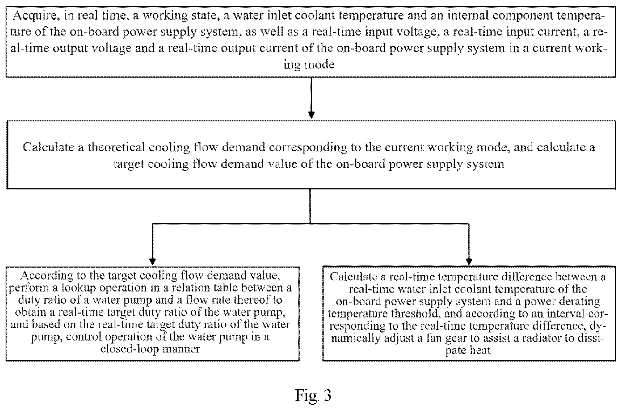

As shown in Fig. 3, in present embodiment, the cooling control method for an on-board power supply system further includes calculating a real-time temperature difference between a real-time water inlet coolant temperature of the on-board power supply system and a power derating temperature threshold, and according to an interval corresponding to the real-time temperature difference, dynamically adjusting a fan gear to assist a radiator to dissipate heat.

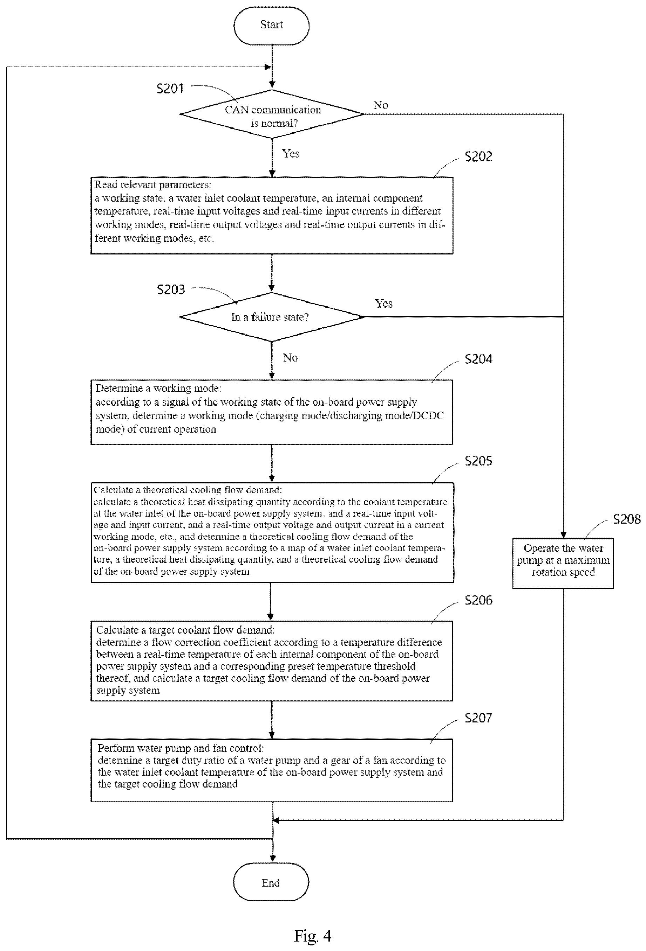

With respect to the above-described cooling control method for an on-board power supply system 10, in conjunction with Fig. 4, specific cooling control logic of the on-board power supply system is further described in detail by using an application example (data listed in the following tables are only for the purpose of explaining the control method, and accurate design values need to be determined by testing and calibration based on an actual state of the on-board power supply system to be cooled):

Step S201: determining whether CAN communication of a vehicle is currently normal; if so, proceeding to step S202; and if not, proceeding to step S208.

Step S202: reading relevant parameters: reading, in real time, message signals corresponding to required parameters through CAN communication, determining current states of the vehicle and the on-board power supply system to be cooled, acquiring a real-time working state of the on-board power supply system to be cooled, a real-time coolant temperature at a water inlet, a real-time temperature of each internal component and a preset temperature threshold thereof, as well as real-time input voltages, real-time input currents, real-time output voltages, real-time output currents, and other parameters of the on-board power supply system to be cooled in different working modes.

Step S203: based on the real-time working state of the on-board power supply system to be cooled obtained in step S202, determining whether the on-board power supply system is currently in a failure state; if not, proceeding to step S204; and if so, proceeding to step S208.

Step S204, determining a working mode: according to the real-time working state of the on-board power supply system obtained in step S202, determining a current working mode (charging mode/discharging mode/DCDC mode) of the on-board power supply system to be cooled.

Step S205, calculating a theoretical cooling flow demand: according to the real-time coolant temperature at the water inlet of the on-board power supply system to be cooled obtained in step S202, and values of a real-time input voltage, a real-time input current, a real-time output voltage, a real-time output current, and other parameter in the working mode corresponding to step S204, determining a theoretical cooling flow demand ($CF_{\_Basic}$) of the on-board power supply system, specifically as follows:

a: according to a value of an actual water inlet coolant temperature ($T_{cool\_0}$) of the on-board power supply system, looking up a corresponding relation table between a heat dissipating quantity of the on-board power supply system and a base coolant flow rate, in Table 1.

Table 1: correspondence relation table between a coolant temperature and relation tables between the heat dissipating quantity of the on-board power supply system and the base flow rate

| $T_{cool\ 0}$ (C) | [-40, -25] | (-25, 0] | (0, 30] | (30, 65] | (65, 85] |
|---|---|---|---|---|---|
| Relation correspondence table | Table 2 | Table 3 | Table 4 | Table 5 | Table 6 |

b: calculating a theoretical heat dissipating quantity of the on-board power supply system according to the working mode of the on-board power supply system determined in step S204 and the values of the real-time input voltage, the real-time input current, the real-time output voltage, the real-time output current, and other parameter corresponding thereto, specifically as follows:

If the charging mode is identified according to step S204, then:

$$Q_{ACDC}=U_{ACDC\_in}*I_{ACDC\_in}-U_{ACDC\_out}*I_{ACDC\_out}-U_{DCDC\_out}*I_{DCDC\_out}$$

wherein $Q_{ACDC}$ denotes a theoretical heat dissipating quantity (unit: W) when the on-board power supply system to be cooled is in the charging mode, $U_{ACDC\_in}$ denotes a real-time input voltage (unit: V) at an AC terminal of the on-board power supply system to be cooled, $I_{ACDC\_in}$ denotes a real-time input current (unit: A) at the AC terminal of the on-board power supply system to be cooled, $U_{ACDC\_out}$ denotes a real-time charging voltage (unit: V) of the on-board power supply system to be cooled, $I_{ACDC\_out}$ denotes a real-time charging current (unit: A) of the on-board power supply system to be cooled, $U_{DCDC\_out}$ denotes a DCDC low-voltage-side voltage (unit: V) of the on-board power supply system to be cooled, and $I_{DCDC\_out}$ denotes a DCDC low-voltage-side current (unit: A) of the on-board power supply system to be cooled.

If the discharging mode is identified according to step S204, then:

$$Q_{DCAC}=U_{DCAC\_in}*I_{DCAC\_in}-U_{DCAC\_out}*I_{DCAC\_out}-U_{DCDC\_out}*I_{DCDC\_out}$$

wherein $Q_{DCAC}$ denotes a theoretical heat dissipating quantity (unit: W) when the on-board power supply system to be cooled is in the discharging mode, $U_{DCAC\_in}$ denotes a DCAC input voltage (unit: V) of the on-board power supply system to be cooled, $I_{DCAC\_in}$ denotes a DCAC input current (unit: A) of the on-board power supply system to be cooled, $U_{DCAC\_out}$ denotes a DCAC output voltage (unit: V) of the on-board power supply system to be cooled, $I_{DCAC\_out}$ denotes a DCAC output current (unit: A) of the on-board power supply system to be cooled, $U_{DCDC\_out}$ denotes a DCDC low-voltage-side voltage (unit: V) of the on-board power supply system to be cooled, and $I_{DCDC\_out}$ denotes a DCDC low-voltage-side current (unit: A) of the on-board power supply system to be cooled.

If the DCDC mode is identified according to step S204, then:

$$Q_{DCDC}=U_{DCDC\_in}*I_{DCDC\_in}-U_{DCDC\_out}*I_{DCDC\_out}$$

wherein $Q_{DCDC}$ denotes a theoretical heat dissipating quantity (unit: W) when the on-board power supply system to be cooled is in the DCDC mode, $U_{DCDC\_in}$ denotes a DCDC high-voltage-side voltage (unit: V) of the on-board power supply system to be cooled, $I_{DCDC\_in}$ denotes a DCDC high-voltage-side current (unit: A) of the on-board power supply system to be cooled, $U_{DCDC\_out}$ denotes a DCDC low-voltage-side voltage (unit: V) of the on-board power supply system to be cooled, and $I_{DCDC\_out}$ denotes a DCDC low-voltage-side current (unit: A) of the on-board power supply system to be cooled.

c: according to the current working mode and the theoretical heat dissipating quantity of the on-board power supply system, looking up a corresponding demanded base coolant flow rate (unit: L/min), in the relation correspondence table that has been determined in the step a.

Table 2: relation table between a heat dissipating quantity of the on-board power supply system and a base coolant flow rate ($-40°C \leq T_{cool\_0} \leq -25°C$)

| Heat dissipating quantity (W) Coolant flow rate (L/min) Working mode | 50 | 100 | 150 | 200 | 300 | 400 | 500 | 600 | 800 | 1000 |
|---|---|---|---|---|---|---|---|---|---|---|
| Charging mode | 0.8 | 0.9 | 1.0 | 1.5 | 2.0 | 2.5 | 2.8 | 3.0 | 3.5 | 4.0 |

| | | | | | | | | | | |
|---|---|---|---|---|---|---|---|---|---|---|
| Discharging mode | 0.6 | 0.7 | 0.9 | 1.3 | 1.5 | 2.0 | 2.5 | 2.8 | 3.0 | 3.5 |
| DCDC mode | 0.7 | 0.8 | 0.9 | 1.5 | 1.8 | 2.2 | 2.6 | 3.0 | 3.3 | 3.9 |

Table 3: relation table between a heat dissipating quantity of the on-board power supply system and a base coolant flow rate ($-25°C < T_{cool\_0} \leq 0°C$)

| Heat dissipating quantity (W) / Coolant flow rate (L/min) / Working mode | 50 | 100 | 150 | 200 | 300 | 400 | 500 | 600 | 800 | 1000 |
|---|---|---|---|---|---|---|---|---|---|---|
| Charging mode | 1.0 | 1.2 | 1.5 | 1.8 | 2.5 | 2.8 | 3.0 | 3.4 | 3.8 | 4.5 |
| Discharging mode | 0.8 | 1.0 | 1.5 | 1.8 | 2.0 | 2.5 | 2.8 | 3.0 | 3.5 | 4.0 |
| DCDC mode | 0.9 | 1.1 | 1.4 | 1.7 | 2.3 | 2.5 | 2.8 | 3.2 | 3.6 | 4.0 |

Table 4: relation table between a heat dissipating quantity of the on-board power supply system and a base coolant flow rate ($0°C < T_{cool\_0} \leq 30°C$)

| Heat dissipating quantity (W) / Coolant flow rate (L/min) / Working mode | 50 | 100 | 150 | 200 | 300 | 400 | 500 | 600 | 800 | 1000 |
|---|---|---|---|---|---|---|---|---|---|---|
| Charging mode | 1.5 | 1.8 | 2.0 | 2.5 | 3.0 | 3.5 | 4.5 | 6.0 | 7.0 | 8.0 |
| Discharging mode | 1.3 | 1.6 | 2.0 | 2.3 | 2.7 | 3.2 | 3.7 | 4.5 | 5.5 | 6.5 |
| DCDC mode | 1.5 | 1.8 | 2.0 | 2.2 | 2.8 | 3.4 | 4.0 | 5.0 | 6.0 | 7.0 |

Table 5: relation table between a heat dissipating quantity of the on-board power supply system and a base coolant flow rate ($30°C < T_{cool\_0} \leq 65°C$)

| Coolant flow rate (L/min) / Heat dissipating quantity (W) / Working mode | 50 | 100 | 150 | 200 | 300 | 400 | 500 | 600 | 800 | 1000 |
|---|---|---|---|---|---|---|---|---|---|---|
| Charging mode | 2.0 | 2.5 | 3.0 | 4.0 | 5.0 | 5.5 | 6.5 | 8.0 | 9.0 | 9.0 |
| Discharging mode | 1.5 | 2.0 | 2.4 | 3.0 | 3.5 | 4.0 | 5.5 | 6.5 | 7.5 | 8.5 |
| DCDC mode | 2.0 | 2.0 | 2.5 | 3.2 | 4.0 | 4.5 | 5.0 | 6.0 | 8.0 | 9.0 |

Table 6: relation table between a heat dissipating quantity of the on-board power supply system and a base coolant flow rate ($65°C < T_{cool\_0} \leq 85°C$)

| Coolant flow rate (L/min) / Heat dissipating quantity (W) / Working mode | 50 | 100 | 150 | 200 | 300 | 400 | 500 | 600 | 800 | 1000 |
|---|---|---|---|---|---|---|---|---|---|---|
| Charging mode | 2.5 | 3.0 | 3.5 | 4.5 | 5.5 | 6.5 | 8.0 | 9.0 | 9.0 | 9.0 |
| Discharging mode | 1.9 | 2.5 | 3.0 | 3.5 | 4.5 | 5.5 | 6.5 | 8.0 | 9.0 | 9.0 |
| DCDC mode | 2.5 | 3.0 | 3.0 | 4.0 | 4.5 | 6.0 | 7.0 | 8.0 | 9.0 | 9.0 |

Step S206, calculating a target coolant flow demand:

determining a flow correction coefficient according to the real-time temperature of each internal component of the on-board power supply system to be cooled and the preset temperature threshold thereof obtained in step S202, and calculating a target cooling flow demand value ($CF_{\_Real}$) of the on-board power supply system, specifically as follows:

(1) Determining a flow correction coefficient ($K_{int\_n}$) according to a temperature difference ($\Delta T_{int\_n} = T_{Limit\_n} - T_{Real\_n}$) between a preset temperature threshold ($T_{Limit\_n}$) of each key internal component of the on-board power supply system and a real-time temperature ($T_{real\_n}$) thereof

wherein the value of n is 1-6, and the range of n should be determined according to the actual application, and this is not the only value range in present embodiment.

Here, the cooling control of the on-board power supply system is intended to achieve that in any working state, the real-time temperature $T_{Real\_n}$ of each internal component does not exceed the preset temperature threshold $T_{Limit\_n}$ corresponding thereto, and the lower the real-time temperature $T_{Real\_n}$, the smaller the cooling flow demand.

Table 7: relation table between a flow correction coefficient and a temperature difference ($\Delta T_{int\_n}$) corresponding to each key internal component of the on-board power supply system

| Temperature difference (°C) / Correction coefficient / Internal component | 0 | 5 | 10 | 15 | 30 | 50 | 80 | 120 | 160 |
|---|---|---|---|---|---|---|---|---|---|
| Internal component 1, $K_{int\_1}$ | 2.0 | 1.8 | 1.6 | 1.5 | 1.2 | 1.1 | 1.0 | 0.9 | 0.8 |
| Internal component 2, $K_{int\_2}$ | 1.8 | 1.5 | 1.3 | 1.2 | 1.0 | 1.0 | 0.9 | 0.8 | 0.8 |
| Internal component 3, $K_{int\_3}$ | 1.8 | 1.6 | 1.5 | 1.2 | 1.1 | 1.0 | 1.0 | 0.9 | 0.8 |
| Internal component 4, $K_{int\_4}$ | 1.6 | 1.3 | 1.2 | 1.1 | 1.0 | 1.0 | 0.9 | 0.8 | 0.8 |
| Internal component 5, $K_{int\_5}$ | 1.7 | 1.5 | 1.3 | 1.1 | 1.1 | 1.0 | 1.0 | 0.9 | 0.8 |
| Internal component 6, $K_{int\_6}$ | 1.8 | 1.6 | 1.5 | 1.2 | 1.1 | 1.0 | 0.9 | 0.8 | 0.8 |

Here, the key internal components need to be determined according to the specific design scheme and structural arrangement of the on-board power supply system to be cooled, and the key internal components that need to be monitored actually are determine by means of CAE thermal simulation and NTC temperature sensor placement testing, etc., and the types and number of the key internal components are not the only implementation of this example.

(2) Calculating a flow correction coefficient $K_{int\_0}$ of the on-board power supply system.

$$K_{int\_0}=Max(K_{int\_1},K_{int\_2},K_{int\_3},\ldots,K_{int\_n})$$

wherein $K_{int\_n}$ denotes a flow correction coefficient corresponding to a key internal component n of the on-board power supply system obtained by interpolation according to Table 7.

(3) Calculating a target cooling flow demand value $CF_{\_Real}$ of the on-board power supply system.

$$CF_{\_Real}=CF_{\_Basic}*K_{int\_0}$$

wherein $CF_{\_Basic}$ denotes the theoretical cooling flow demand of the on-board power supply system obtained by interpolation according to Tables 1 to 6, and $K_{int\_0}$ denotes the flow correction coefficient of the on-board power supply system.

Step S207, performing water pump and fan control:
adjusting, in real time, the operation of a water pump and a fan to achieve cooling temperature control of a cooling circulation loop of the on-board power supply system.

A control method for the water pump and the fan is specifically as follows:
according to the target cooling flow demand value $CF_{\_Real}$ of the on-board power supply system determined in step S206, performing a table lookup operation by interpolation to obtain a corresponding duty ratio of the water pump, and controlling the water pump to a target duty ratio in a closed-loop manner. An implementation is exemplified below:

Table 8: relation table between a duty ratio and a flow rate of the water pump

| Flow rate (L/min) | 0 | 1 | 2 | 4 | 6 | 7 | 8 | 9 |
|---|---|---|---|---|---|---|---|---|
| Duty ratio (%) | 0 | 8 | 15 | 50 | 65 | 85 | 90 | 100 |
| Rotation speed (rpm) | 0 | 500 | 1500 | 2200 | 3500 | 4000 | 5000 | 5500 |

Here, duty ratios and rotation speeds of the water pump at corresponding target flows are calibrated results at standard temperature (25°C), and with a certain safety margin being considered in the above flow calculation process, the influence of temperature change on the flow is ignored for the duty ratio of the water pump in present embodiment.

According to a difference between the actual water inlet coolant temperature $T_{cool\_0}$ of the on-board power supply system obtained in step S202 and a power derating coolant temperature 65°C ($\Delta T_{cool} = T_{cool\_0}$ - 65), a lookup operation is performed in Table 9 to obtain a gear of the radiator fan, so that the coolant temperature in the cooling circulation loop can be actively adjusted in real time. An implementation is exemplified below:

Table 9: Relation between a fan gear and a coolant temperature difference

| Temperature difference (°C) | Fan gear | Duty ratio |
|---|---|---|
| $\Delta T_{cool}\leq$-15 | Gear 0 | 0 |
| -15<$\Delta T_{cool}\leq$-10 | Gear 1 | 10% |
| -10<$\Delta T_{cool}\leq$-5 | Gear 2 | 30% |
| -5<$\Delta T_{cool}\leq$0 | Gear 3 | 50% |
| 0<$\Delta T_{cool}\leq$10 | Gear 4 | 80% |
| 10<$\Delta T_{cool}\leq$20 | Gear 5 | 100% |

Here, a stepless speed regulation fan is usually used. In order to facilitate control, the fan generally has 3-10 gears in the actual application of the whole vehicle, and gear selection and matching is performed according to a heat dissipation demand. Relevant data shown in the present invention is only used for the purpose of describing the technical solution, and is not the only implementation of fan control.

By using the cooling control method for an on-board power supply system provided in present embodiment, adaptive and active real-time flow correction can be performed in conjunction with the specific technical solution of this on-board power supply system to be cooled, and the duty ratios of the water pump and the radiator fan can be dynamically adjusted, so the method is refined and energy-saving compared with existing wide-temperature-range constant-flow cooling methods.

The cooling control process for an on-board power supply system illustrated in the above steps S201 to S207 is a cooling control method and process when the vehicle and the on-board power supply system are in a normal working state. In a non-normal working state, to prevent an unknown uncontrollable thermal failure, which would otherwise cause damage to the on-board power supply system to be cooled, for such a situation, a preset cooling control method is operating the water pump at a maximum rotation speed, as in step S208.

Here, the non-normal working state includes, but is not limited to, such representation forms as high voltage failure, power loss of a power battery or storage battery, CAN communication abnormality, poor line connection, and a fault reporting mode on the vehicle.

In this method, corresponding real-time input voltages and currents and real-time output voltages and currents of the on-board power supply system in different working modes are acquired, a theoretical heat dissipating quantity is calculated, and a lookup operation is performed in a table according to a map of heat dissipating quantity versus flow determined by testing and calibration to obtain a theoretical cooling flow demand; a target cooling flow demand of the on-board power supply system is calculated according to a preset map of internal component temperature of the on-board power supply system versus correction coefficient; a theoretical flow of a motor controller to be cooled is calculated according to real-time power of the motor controller and a real-time coolant temperature; operation of a water pump is adaptively and dynamically adjusted according to a preset map of water pump flow versus duty ratio; and operation of a fan is actively adjusted in real time according to a preset map of water inlet coolant temperature of the on-board power supply system versus fan gear. **In** this method, the control of the water pump and the fan is based on a real-time flow demand of the on-board power supply system to implement active, adaptive and dynamic adjustment. Compared with a wide-range constant-current cooling method that usually determines a flow of a water pump based on a coolant temperature, the control is more accurate and refined, long-time high-speed operation of the water pump can be avoided, the NVH is significantly improved, and the cooling process is more energy-efficient under the premise of meeting the actual cooling demand of the on-board power supply system. Meanwhile, the selection of components of the cooling system can be optimized, and the cost of the whole vehicle is reduced.

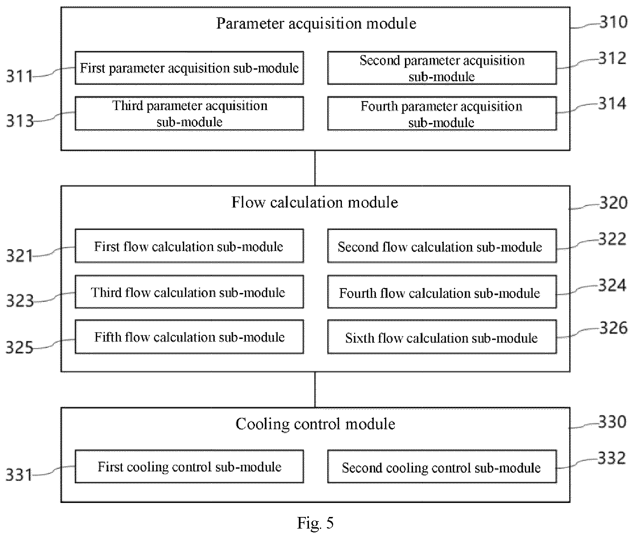

Corresponding to the cooling control method for an on-board power supply system in the above embodiment, the present embodiment also provides a cooling control apparatus for an on-board power supply system, applied to a vehicle thermal management controller, wherein a water pump and a fan of the on-board power supply system to be cooled are respectively electrically connected to the vehicle thermal management controller. The coolant temperature control is performed on the on-board power supply system to be cooled, by using the water pump and the fan. As can be seen in Fig. 5, the apparatus includes a parameter acquisition module 310, a flow calculation module 320, and a cooling control module 330. Functions of the modules are described in detail below.

The parameter acquisition module 310 is configured to acquire a working state of the on-board power supply system, a water inlet coolant temperature, an internal component temperature, a real-time input voltage/current, a real-time output voltage/output current and other parameters of the on-board power supply system, as well as a computation strategy corresponding to a current working mode of the on-board power supply system. Message signals corresponding to the required parameters described above are read in real time by CAN communication.

In present embodiment, the parameter acquisition module 310 includes sub-modules as follows:
A first parameter acquisition sub-module 311 is configured to acquire a current working mode of the on-board power supply system according to a current working state of an automobile and a using scenario thereof. Specifically:

when the automobile is in a use scenario of plug-in charge, or remote reservation charge, the current working mode of the on-board power supply system is determined to be a charging mode;
when the automobile is in a use scenario of plug-in discharge or in-vehicle discharge, vehicle-vehicle discharge, vehicle-grid discharge, or the like (depending on an actually available discharging function), the current working mode of the on-board power supply system is determined to be a discharging mode; and
in a use scenario the automobile is in a power-up state and a power battery supplies power to low-voltage loads of the whole vehicle or charges a storage battery, the current working mode of the on-board power supply system is determined to be a DCDC mode.

A second parameter acquisition sub-module 312 is configured to acquire a corresponding first flow calculation strategy when the current working mode of the on-board power supply system is a charging mode.

A third parameter acquisition sub-module 313 is configured to acquire a corresponding second flow calculation strategy when the current working mode of the on-board power supply system is a discharging mode.

A fourth parameter acquisition sub-module 314 is configured to acquire a corresponding third flow calculation strategy when the current working mode of the on-board power supply system is a DCDC mode.

In present embodiment, the flow calculation module 320 is configured to calculate a corresponding theoretical flow demand and target flow demand according to the current working mode of the on-board power supply system and the corresponding parameters determined by the parameter acquisition module 310.

The flow calculation module 320 includes sub-modules as follows:

A first flow calculation sub-module 321 is configured to calculate a corresponding theoretical cooling flow demand when the current working mode of the on-board power supply system is the charging mode, specifically:

first, according to a real-time input voltage $U_{ACDC\_in}$ at an AC terminal of the on-board power supply system to be cooled, a real-time input current $I_{ACDC\_in}$ at the AC terminal of the on-board power supply system to be cooled, a real-time charging voltage $U_{ACDC\_out}$ of the on-board power supply system to be cooled, a real-time charging current $I_{ACDC\_out}$ of the on-board power supply system to be cooled, a DCDC low-voltage-side voltage $U_{DCDC\_out}$ of the on-board power supply system to be cooled, a DCDC low-voltage-side current $I_{DCDC\_out}$ of the on-board power supply system to be cooled, which are obtained by the parameter acquisition module 310, calculate a theoretical heat dissipating quantity when the on-board power supply system to be cooled is in the charging mode: $Q_{ACDC}=U_{ACDC\_in}*I_{ACDC\_in}-U_{ACDC\_out}*I_{ACDC\_out}-U_{DCDC\_out}*I_{DCDC\_out}$; second, according to the first flow calculation strategy corresponding to the second parameter acquisition sub-module 312, determine a corresponding theoretical cooling flow demand $CF_{\_Basic}$ by performing a table lookup operation.

A second flow calculation sub-module 322 is configured to calculate a corresponding theoretical cooling flow demand when the current working mode of the on-board power supply system is the discharging mode, specifically:

first, according to a DCAC input voltage $U_{DCAC\_in}$ of the on-board power supply system to be cooled, a DCAC input current $I_{DCAC\_in}$ of the on-board power supply system to be cooled, a DCAC output voltage $U_{DCAC\_out}$ of the on-board power supply system to be cooled, a DCAC output current $I_{DCAC\_out}$ of the on-board power supply system to be cooled, a DCDC low-voltage-side voltage $U_{DCDC\_out}$ of the on-board power supply system to be cooled, a DCDC low-voltage-side current $I_{DCDC\_out}$ of the on-board power supply system to be cooled, which are obtained by the parameter acquisition module 310, calculate a theoretical heat dissipating quantity when the on-board power supply system to be cooled is in the discharging mode: $Q_{DCAC}=U_{DCAC\_in}*I_{DCAC\_in}-U_{DCAC\_out}*I_{DCAC\_out}-U_{DCDC\_out}*I_{DCDC\_out}$; second, according to the second flow calculation strategy corresponding to the third parameter acquisition sub-module 313, determine a corresponding theoretical cooling flow demand $CF_{\_Basic}$ by performing a table lookup operation.

A third flow calculation sub-module 323 is configured to calculate a corresponding theoretical cooling flow demand when the current working mode of the on-board power supply system is the DCDC mode, specifically:

first, according to a DCDC high-voltage-side voltage $U_{DCDC\_in}$ of the on-board power supply system to be cooled, a DCDC high-voltage-side current $I_{DCDC\_in}$ of the on-board power supply system to be cooled, a DCDC low-voltage-side voltage $U_{DCDC\_out}$ of the on-board power supply system to be cooled, and a DCDC low-voltage-side current $I_{DCDC\_out}$ of the on-board power supply system to be cooled, which are obtained by the parameter acquisition module 310, calculate a theoretical heat dissipating quantity when the on-board power supply system to be cooled is in the DCDC mode: $Q_{DCDC}=U_{DCDC\_in}*I_{DCDC\_in}-U_{DCDC\_out}*I_{DCDC\_out}$; second, according to the third flow calculation strategy corresponding to the third parameter acquisition sub-module 314, determine a corresponding theoretical cooling flow demand $CF_{\_Basic}$ by performing a table lookup operation.

A fourth flow calculation sub-module 324 is configured to calculate a corresponding target cooling flow demand value when the current working mode of the on-board power supply system is the charging mode, specifically: according to the theoretical flow demand $CF_{\_Basic}$ obtained by the first flow calculation sub-module 321 and the first flow calculation strategy corresponding to the second parameter acquisition sub-module 312, respectively, determine a corresponding flow correction coefficient $K_{int\_0}$ by performing a table lookup operation, and calculate a corresponding target cooling flow demand value $CF_{\_Real}$, where $CF_{\_Real}=CF_{\_Basic}*K_{int\_0}$.

A fifth flow calculation sub-module 325 is configured to calculate a corresponding target cooling flow demand value when the current working mode of the on-board power supply system is the discharging mode, specifically: according to the theoretical flow demand $CF_{\_Basic}$ obtained by the second flow calculation sub-module 322 and the second flow calculation strategy corresponding to the third parameter acquisition sub-module 313, respectively, determine a corresponding flow correction coefficient $K_{int\_0}$ by performing a table lookup operation, and calculate a corresponding target cooling flow demand value $CF_{\_Real}$, where $CF_{\_Real}=CF_{\_Basic}*K_{int\_0}$.

A sixth flow calculation sub-module 326 is calculate a corresponding target cooling flow demand value when the current working mode of the on-board power supply system is the DCDC mode, specifically: according to the theoretical flow demand $CF_{\_Basic}$ obtained by the third flow calculation sub-module 323 and the third flow calculation strategy corresponding to the fourth parameter acquisition sub-module 314, respectively, determine a corresponding flow correction coefficient $K_{int\_0}$ by performing a table lookup operation, and calculate a corresponding target cooling flow demand value $CF_{\_Real}$, where $CF_{\_Real}=CF_{\_Basic}*K_{int\_0}$.

In present embodiment, the cooling control module 330 is configured to control a water pump and a fan to operate at a corresponding target duty ratio, respectively, according to the current working mode of the on-board power supply system and the corresponding parameters determined by the parameter acquisition module 310, and the target cooling flow demand value determined by the flow calculation module 320.

The cooling control module 330 includes:

a first cooling control sub-module 331 configured to, according to the target cooling flow demand value CF $_{Real}$, perform a table lookup operation to obtain a corresponding duty ratio of the water pump, control the water pump to operate accordingly; and
a second cooling control sub-module 332 configured to, according to the target cooling flow demand value CF $_{Real}$, perform a table lookup operation to obtain a corresponding duty ratio of a fan, and controlling the fan to operate accordingly.

In present embodiment, a vehicle adopts a cooling control system for an on-board power supply system as described in present embodiment.

In present embodiment, a storage medium is configured to store a computer readable program which, when being called, performs steps of the cooling control method for an on-board power supply system as described in present embodiment.

The storage medium of present embodiment includes any of non-volatile and volatile, removable and non-removable media, and may use any method or technology to implement information storage. The information may be computer readable instructions, data structures, program modules, or other data. Examples of computer storage media include, but are not limited to, phase-change memory (PRAM), static random access memory (SRAM), dynamic random access memory (DRAM), other types of random access memory (RAM), read-only memory (ROM), electrically erasable programmable read-only memory (EEPROM), flash memory or other memory technologies, compact disc read-only memory (CD-ROM), digital versatile disk (DVD) or other optical storage, magnetic cartridge tape, magnetic tape disk storage or other magnetic storage devices, or any other non-transmission media, and the media may be used to store information accessible to computer devices.

The above embodiments are preferred implementations of the present invention, but the implementations of the present invention are not limited by the above embodiments, and any other changes, modifications, substitutions, combinations, and simplifications made without departing from the spirit essence and principles of the present invention should be equivalent substitutions, and they are all encompassed within the scope of protection of the present invention.

**Claims**

1. A cooling control method for an on-board power supply system, **characterized by** comprising the following steps:

   acquiring, in real time, a working state, a water inlet coolant temperature and an internal component temperature of the on-board power supply system, as well as a real-time input voltage, a real-time input current, a real-time output voltage and a real-time output current of the on-board power supply system in a current working mode;
   calculating a theoretical cooling flow demand corresponding to the current working mode according to an actual water inlet coolant temperature of the on-board power supply system, and a real-time input voltage, a real-time input current, a real-time output voltage and a real-time output current in a corresponding working mode; and
   according to a difference between a real-time temperature of each internal component of the on-board power supply system and a temperature threshold corresponding thereto, acquiring a flow correction coefficient corresponding to each internal component by referring to a correction coefficient map, taking the maximum of the flow correction coefficient(s) of all internal component(s) to obtain a flow correction coefficient of the on-board power supply system, and calculating a target cooling flow demand value of the on-board power supply system based on the flow correction coefficient of the on-board power supply system and the theoretical cooling flow demand; and
   according to the target cooling flow demand value, performing a lookup operation in a relation table between a duty ratio of a water pump and a flow rate thereof to obtain a real-time target duty ratio of the water pump, and based on the real-time target duty ratio of the water pump, controlling operation of the water pump in a closed-loop manner.

2. The cooling control method for an on-board power supply system according to claim 1, **characterized by** further comprising:
   calculating a real-time temperature difference between a real-time water inlet coolant temperature of the on-board power supply system and a power derating temperature threshold, and according to an interval corresponding to the real-time temperature difference, dynamically adjusting a fan gear to assist a radiator to dissipate heat.

3. The cooling control method for an on-board power supply system according to claim 1, **characterized in that** the real-time theoretical cooling flow demand is calculated in the following way:

> a: according to the actual water inlet coolant temperature of the on-board power supply system, looking up a corresponding relation table between a heat dissipating quantity of the on-board power supply system and a base coolant flow rate, in a correspondence relation table between a coolant temperature and relation tables between the heat dissipating quantity of the on-board power supply system and the base coolant flow rate;
> b: calculating a theoretical heat dissipating quantity of the on-board power supply system according to the working mode of the on-board power supply system and the corresponding real-time input voltage, real-time input current, real-time output voltage and real-time output current thereof; and
> c: according to the current working mode of the on-board power supply system and the theoretical heat dissipating quantity, looking up a corresponding demanded base coolant flow rate in the relation table between the heat dissipating quantity of the on-board power supply system and the base coolant flow rate that has been determined in the step a.

4. The cooling control method for an on-board power supply system according to claim 3, **characterized in that**, in the step a, if the working mode identified is a charging mode, the theoretical heat dissipating quantity of the on-board power supply system is calculated by:

$$Q_{ACDC}=U_{ACDC\_in}*I_{ACDC\_in}-U_{ACDC\_out}*I_{ACDC\_out}-U_{DCDC\_out}*I_{DCDC\_out}$$

wherein $Q_{ACDC}$ denotes a theoretical heat dissipating quantity when the on-board power supply system to be cooled is in the charging mode, $U_{ACDC\_in}$ denotes a real-time input voltage at an AC terminal of the on-board power supply system to be cooled, $I_{ACDC\_in}$ denotes a real-time input current at the AC terminal of the on-board power supply system to be cooled, $U_{ACDC\_out}$ denotes a real-time charging voltage of the on-board power supply system to be cooled, $I_{ACDC\_out}$ denotes a real-time charging current of the on-board power supply system to be cooled, $U_{DCDC\_out}$ denotes a DCDC low-voltage-side voltage of the on-board power supply system to be cooled, and $I_{DCDC\_out}$ denotes a DCDC low-voltage-side current of the on-board power supply system to be cooled.

5. The cooling control method for an on-board power supply system according to claim 3, **characterized in that**, in the step a, if the working mode identified is a discharging mode, the theoretical heat dissipating quantity of the on-board power supply system is calculated by:

$$Q_{DCAC}=U_{DCAC\_in}*I_{DCAC\_in}-U_{DCAC\_out}*I_{DCAC\_out}-U_{DCDC\_out}*I_{DCDC\_out}$$

wherein $Q_{DCAC}$ denotes a theoretical heat dissipating quantity when the on-board power supply system to be cooled is in the discharging mode, $U_{DCAC\_in}$ denotes a DCAC input voltage of the on-board power supply system to be cooled, $I_{DCAC\_in}$ denotes a DCAC input current of the on-board power supply system to be cooled, $U_{DCAC\_out}$ denotes a DCAC output voltage of the on-board power supply system to be cooled, $I_{DCAC\_out}$ denotes a DCAC output current of the on-board power supply system to be cooled, $U_{DCDC\_out}$ denotes a DCDC low-voltage-side voltage of the on-board power supply system to be cooled, and $I_{DCDC\_out}$ denotes a DCDC low-voltage-side current of the on-board power supply system to be cooled.

6. The cooling control method for an on-board power supply system according to claim 3, **characterized in that**, in the step a, if the working mode identified is a DCDC mode, the theoretical heat dissipating quantity for the on-board power supply system is calculated by:

$$Q_{DCDC}=U_{DCDC\_in}*I_{DCDC\_in}-U_{DCDC\_out}*I_{DCDC\_out}$$

wherein $Q_{DCDC}$ denotes a theoretical heat dissipating quantity when the on-board power supply system to be cooled is in the DCDC mode, $U_{DCDC\_in}$ denotes a DCDC high-voltage-side voltage of the on-board power supply system to be cooled, $I_{DCDC\_in}$ denotes a DCDC high-voltage-side current of the on-board power supply system to be cooled, $U_{DCDC\_out}$ denotes a DCDC low-voltage-side voltage of the on-board power supply system to be cooled, and $I_{DCDC\_out}$ denotes a DCDC low-voltage-side current of the on-board power supply system to be cooled.

7. The cooling control method for an on-board power supply system according to claim 3, **characterized in that** the target cooling flow demand value is calculated by:

$$CF_{\_Real} = C_{F\_Basic} * K_{int\_0}$$

wherein $C_{F\_Real}$ denotes the target cooling flow demand value; $C_{F\_Basic}$ denotes the theoretical cooling flow demand of the on-board power supply system; and $K_{int\_0}$ denotes the flow correction coefficient of the on-board power supply system.

8. A cooling control system for an on-board power supply system, **characterized by** comprising:

a parameter acquisition module (310) configured to acquire a working state, a water inlet coolant temperature and an internal component temperature of the on-board power supply system, as well as a real-time input voltage, a real-time input current, a real-time output voltage and a real-time output current of the on-board power supply system in a current working mode;

a flow calculation module (320) configured to calculate a theoretical cooling flow demand corresponding to the current working mode according to an actual water inlet coolant temperature of the on-board power supply system, and a real-time input voltage, a real-time input current, a real-time output voltage and a real-time output current in a corresponding working mode; and according to a difference between a real-time temperature of each internal component of the on-board power supply system and a temperature threshold corresponding thereto, acquiring a flow correction coefficient corresponding to each internal component by referring to a correction coefficient map, take the maximum of the flow correction coefficient(s) of all internal component(s) to obtain a flow correction coefficient of the on-board power supply system, and calculate a target cooling flow demand value of the on-board power supply system based on the flow correction coefficient of the on-board power supply system and the theoretical cooling flow demand, the flow calculation module (320) being connected with the parameter acquisition module (310);

and a cooling control module (330) configured to, according to the target cooling flow demand value, perform a lookup operation in a relation table between a duty ratio of a water pump and a flow rate thereof to obtain a real-time target duty ratio of the water pump, and based on the real-time target duty ratio of the water pump, control operation of the water pump in a closed-loop manner, the cooling control module (330) being connected with the flow calculation module (320).

9. The cooling control system for an on-board power supply system according to claim 8, **characterized in that** the cooling control module (330) is further configured to calculate a real-time temperature difference between a real-time water inlet coolant temperature of the on-board power supply system and a power derating temperature threshold, and according to an interval corresponding to the real-time temperature difference, dynamically adjust a fan gear to assist a radiator to dissipate heat.

10. The cooling control system for an on-board power supply system according to claim 8, **characterized in that** the parameter acquisition module (310) comprises:

a first parameter acquisition sub-module (311) configured to acquire a current working mode of the on-board power supply system according to a current working state of an automobile and a using scenario thereof;

a second parameter acquisition sub-module (312) configured to acquire a corresponding first flow calculation strategy when the current working mode of the on-board power supply system is a charging mode;

a third parameter acquisition sub-module (313) configured to acquire a corresponding second flow calculation strategy when the current working mode of the on-board power supply system is a discharging mode; and

a fourth parameter acquisition sub-module (314) configured to acquire a corresponding third flow calculation strategy when the current working mode of the on-board power supply system is a DCDC mode.

11. The cooling control system for an on-board power supply system according to claim 10, **characterized in that** the flow calculation module (320) comprises:

a first flow calculation sub-module (321) configured to calculate a corresponding theoretical cooling flow demand when the current working mode of the on-board power supply system is the charging mode;

a second flow calculation sub-module (322) configured to calculate a corresponding theoretical cooling flow demand when the current working mode of the on-board power supply system is the discharging mode;

a third flow calculation sub-module (323) configured to calculate a corresponding theoretical cooling flow demand when the current working mode of the on-board power supply system is the DCDC mode;

a fourth flow calculation sub-module (324) configured to calculate a corresponding target cooling flow demand value when the current working mode of the on-board power supply system is the charging mode;

a fifth flow calculation sub-module (325) configured to calculate a corresponding target cooling flow demand value when the current working mode of the on-board power supply system is the discharging mode; and

a sixth flow calculation sub-module (326) configured to calculate a corresponding target cooling flow demand value when the current working mode of the on-board power supply system is the DCDC mode.

12. The cooling control system for an on-board power supply system according to claim 10, **characterized in that** the cooling control module (330) comprises:

a first cooling control sub-module (331) configured to, according to the target cooling flow demand value, perform a table lookup operation to obtain a corresponding duty ratio of the water pump, and control the water pump to operate accordingly.

13. The cooling control system for an on-board power supply system according to claim 11, **characterized in that** the cooling control module (330) comprises:

a first cooling control sub-module (331) configured to, according to the target cooling flow demand value, perform a table lookup operation to obtain a corresponding duty ratio of the water pump, and control the water pump to operate accordingly; and

a second cooling control sub-module (332) configured to, according to the target cooling flow demand value, perform a table lookup operation to obtain a corresponding duty ratio of a fan, and control the fan to operate accordingly.

14. An automobile, **characterized by** having the cooling control system for an on-board power supply system according to any one of claims 8 to 13.

15. A storage medium, **characterized in that** a computer-readable program is stored therein, wherein the computer-readable program, when being called, causes the steps of the cooling control method for an on-board power supply system according to any one of claims 1 to 7 to be performed.

```
┌─────────────────────────┐
│  Temperature collector  │
│           15            │
└─────────────────────────┘
```

Temperature collector 15

On-board power supply system 10

Radiator 13

Fan 14

Water pump 12

Water storage kettle 11

Fig. 1

Acquire, in real time, a working state, a water inlet coolant temperature and an internal component temperature of the on-board power supply system, as well as a real-time input voltage, a real-time input current, a real-time output voltage and a real-time output current of the on-board power supply system in a current working mode

Calculate a theoretical cooling flow demand corresponding to the current working mode, and calculate a target cooling flow demand value of the on-board power supply system

According to the target cooling flow demand value, perform a lookup operation in a relation table between a duty ratio of a water pump and a flow rate thereof to obtain a real-time target duty ratio of the water pump, and based on the real-time target duty ratio of the water pump, control operation of the water pump in a closed-loop manner

Fig. 2

Acquire, in real time, a working state, a water inlet coolant temperature and an internal component temperature of the on-board power supply system, as well as a real-time input voltage, a real-time input current, a real-time output voltage and a real-time output current of the on-board power supply system in a current work-
ing mode

Calculate a theoretical cooling flow demand corresponding to the current working mode, and calculate a
target cooling flow demand value of the on-board power supply system

According to the target cooling flow demand value,
perform a lookup operation in a relation table between a
duty ratio of a water pump and a flow rate thereof to
obtain a real-time target duty ratio of the water pump,
and based on the real-time target duty ratio of the water
pump, control operation of the water pump in a
closed-loop manner

Calculate a real-time temperature difference between a
real-time water inlet coolant temperature of the
on-board power supply system and a power derating
temperature threshold, and according to an interval corresponding to the real-time temperature difference, dynamically adjust a fan gear to assist a radiator to dissi-
pate heat

Fig. 3

Start

S201

CAN communication
is normal?    No

Yes    S202

Read relevant parameters:
a working state, a water inlet coolant temperature, an internal component
temperature, real-time input voltages and real-time input currents in different
working modes, real-time output voltages and real-time output currents in dif-
ferent working modes, etc.

S203

In a failure state?    Yes

No    S204

Determine a working mode:
according to a signal of the working state of the on-board power supply
system, determine a working mode (charging mode/discharging mode/DCDC
mode) of current operation

S205

Calculate a theoretical cooling flow demand:
calculate a theoretical heat dissipating quantity according to the coolant temperature
at the water inlet of the on-board power supply system, and a real-time input volt-
age and input current, and a real-time output voltage and output current in a current
working mode, etc., and determine a theoretical cooling flow demand of the
on-board power supply system according to a map of a water inlet coolant tempera-
ture, a theoretical heat dissipating quantity, and a theoretical cooling flow demand
of the on-board power supply system

S208

Operate the water
pump at a maximum
rotation speed

S206

Calculate a target coolant flow demand:
determine a flow correction coefficient according to a temperature difference
between a real-time temperature of each internal component of the on-board
power supply system and a corresponding preset temperature threshold
thereof, and calculate a target cooling flow demand of the on-board power
supply system

S207

Perform water pump and fan control:
determine a target duty ratio of a water pump and a gear of a fan according to
the water inlet coolant temperature of the on-board power supply system and
the target cooling flow demand

End

Fig. 4

| Parameter acquisition module | | 310 |
|---|---|---|
| First parameter acquisition sub-module | Second parameter acquisition sub-module | 312 |
| Third parameter acquisition sub-module | Fourth parameter acquisition sub-module | 314 |

311

313

| Flow calculation module | | 320 |
|---|---|---|
| First flow calculation sub-module | Second flow calculation sub-module | 322 |
| Third flow calculation sub-module | Fourth flow calculation sub-module | 324 |
| Fifth flow calculation sub-module | Sixth flow calculation sub-module | 326 |

321

323

325

| Cooling control module | | 330 |
|---|---|---|
| First cooling control sub-module | Second cooling control sub-module | 332 |

331

Fig. 5

## INTERNATIONAL SEARCH REPORT

| International application No. |
| --- |
| **PCT/CN2024/076053** |

| A. | CLASSIFICATION OF SUBJECT MATTER |
| --- | --- |

H05K7/20(2006.01)i

According to International Patent Classification (IPC) or to both national classification and IPC

| B. | FIELDS SEARCHED |
| --- | --- |

Minimum documentation searched (classification system followed by classification symbols)

IPC: H05K, B60K

Documentation searched other than minimum documentation to the extent that such documents are included in the fields searched

Electronic data base consulted during the international search (name of data base and, where practicable, search terms used)

CNTXT, ENTXT, WPABS, CNKI, IEEE: 车载, 电源, 冷却, 进口, 温度, 输入, 电压, 电流, 输出, 理论, 流量, 实时, 阈值, 修正, 目标, 泵, 占空比, 闭环, 功率, vihecle, supply, cooling, inlet, temperature, input, voltage, current, output, theory, flow, real time, threshold, correction, target, pump, duty cycle, closed loop, power

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 116709743 A (CHONGQING CHANG'AN AUTOMOBILE CO., LTD.) 05 September 2023 (2023-09-05) claims 1-15 | 1-15 |
| Y | CN 110978974 A (SHANGHAI YUANCHENG AUTOMOBILE TECHNOLOGY CO., LTD.) 10 April 2020 (2020-04-10) description, paragraphs 26-157 | 1-15 |
| Y | CN 112829567 A (JIANGLING MOTORS CO., LTD.) 25 May 2021 (2021-05-25) description, paragraphs 18-26 | 1-15 |
| A | CN 112455212 A (ZHEJIANG GEELY AUTOMOBILE HOLDINGS LIMITED et al.) 09 March 2021 (2021-03-09) description, paragraphs 28-115 | 1-15 |
| A | CN 113187598 A (UNITED AUTOMOTIVE ELECTRONIC SYSTEMS CO., LTD.) 30 July 2021 (2021-07-30) description, paragraphs 33-64 | 1-15 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **22 April 2024** | **24 April 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/076053** |

### C.    DOCUMENTS CONSIDERED TO BE RELEVANT

| Category* | Citation of document, with indication, where appropriate, of the relevant passages | Relevant to claim No. |
| --- | --- | --- |
| A | WO 2022028245 A1 (GREAT WALL MOTOR CO., LTD.) 10 February 2022 (2022-02-10) description, paragraphs 47-120 | 1-15 |

Form PCT/ISA/210 (second sheet) (July 2022)

**INTERNATIONAL SEARCH REPORT**
Information on patent family members

| International application No. |
| --- |
| **PCT/CN2024/076053** |

| Patent document cited in search report | | | Publication date (day/month/year) | Patent family member(s) | Publication date (day/month/year) |
| --- | --- | --- | --- | --- | --- |
| CN | 116709743 | A | 05 September 2023 | None | |
| CN | 110978974 | A | 10 April 2020 | None | |
| CN | 112829567 | A | 25 May 2021 | None | |
| CN | 112455212 | A | 09 March 2021 | None | |
| CN | 113187598 | A | 30 July 2021 | None | |
| WO | 2022028245 | A1 | 10 February 2022 | None | |

Form PCT/ISA/210 (patent family annex) (July 2022)

**EP 4 633 308 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110316006 A